# FASCICULE DE BREVET EUROPEEN

(11) **EP 2 817 850 B1**
(45) Date de publication et mention de la délivrance du brevet: **10.05.2017**
(21) Numéro de dépôt: 13704803.9
(22) Date de dépôt: 19.02.2013
(51) Int. Cl.: H01Q 15/00, H01Q 9/16, H01Q 9/06, H01Q 3/22, H01Q 11/00, H04B 7/00

(54) **DISPOSITIF À BANDE INTERDITE ÉLECTROMAGNÉTIQUE, UTILISATION DANS UN DISPOSITIF ANTENNAIRE ET PROCÉDÉ DE DÉTERMINATION DES PARAMÈTRES DU DISPOSITIF ANTENNAIRE**
ELEKTROMAGNETISCHE BANDLÜCKENVORRICHTUNG, VERWENDUNG DAVON IN EINER ANTENNENVORRICHTUNG UND PARAMETERFESTLEGUNGSVERFAHREN FÜR DIE ANTENNENVORRICHTUNG
ELECTROMAGNETIC BAND GAP DEVICE, USE THEREOF IN AN ANTENNA DEVICE, AND METHOD FOR DETERMINING THE PARAMETERS OF THE ANTENNA DEVICE

(30) Priorité: 23.02.2012 FR 1200528
(43) Date de publication de la demande: 31.12.2014
(73) Titulaire: THALES, 92400 Courbevoie (FR)
(72) Inventeur: COUPA, Yonnec'h, 29200 Brest (FR); JOUSSET, Michel, 29238 Brest (FR); MALLEGOL, Stéphane, 29238 Brest (FR)
(74) Mandataire: Lucas, Laurent Jacques
(86) Numéro de dépôt international: PCT/EP2013/053297
(87) Numéro de publication internationale: WO 2013/124278

(56) Documents cités:
- WO-A2-2004/093244
- FR-A1- 2 916 308
- US-A1- 2002 167 457
- GAO Q ET AL: "Application of metamaterials to ultra-thin radar-absorbing material design", ELECTRONICS LETTERS, IEE STEVENAGE, GB, vol. 41, no. 17, 18 août 2005 (2005-08-18) , pages 936-937, XP006025026, ISSN: 0013-5194, DOI: 10.1049/EL:20051239
- SCHREIDER L ET AL: "Broadband Archimedean spiral antenna above a loaded electromagnetic band gap substrate", 20070205, vol. 1, no. 1, 5 février 2007 (2007-02-05) , pages 212-216, XP006028070,

## Description

La présente invention concerne le domaine des systèmes de télécommunication à très large bande. Elle concerne plus particulièrement, un dispositif à bande interdite électromagnétique, son utilisation dans un dispositif antennaire et un procédé de détermination des paramètres dudit dispositif antennaire.

D'un point de vue théorique, une antenne filaire plane possède une structure symétrique et rayonne de manière bidirectionnelle selon les deux directions orthogonales au plan de l'antenne.

D'une manière générale, ce rayonnement bidirectionnel ne présente pas vraiment d'intérêt. De plus, l'emploi d'antennes installées sur une plate-forme, comme un aéronef par exemple, impose généralement des rayonnements tournés vers l'extérieur de la plate-forme ; ceux tournés vers l'intérieur n'auraient aucun intérêt pour recevoir ou émettre à l'extérieur de la plate-forme. Ainsi, ce type d'antenne est généralement placé sur un support métallisé, pour la rendre unidirectionnelle.

Un problème avec ce support est qu'il perturbe le rayonnement arrière de l'antenne. De plus, il génère des réflexions qui peuvent être destructives pour le rayonnement avant dont on souhaite préserver l'intégrité. Enfin, le support peut également induire des courants de surface et générer lui-même un rayonnement parasite, réduisant ainsi la bande de fréquence de fonctionnement.

Un support idéal devrait ne pas perturber le rayonnement avant, c'est-à-dire tourné vers l'extérieur de la plate-forme, sur la bande de fréquence la plus étendue, et ne pas générer de rayonnement parasite par induction. Il présenterait aussi un encombrement et une masse minimum. De plus, l'élément rayonnant associé au support présenterait un gain le plus élevé possible.

Il est connu dans l'art antérieur, d'utiliser un support comportant une cavité absorbante pour supprimer une partie du rayonnement arrière de l'antenne et préserver le comportement large bande de cette dernière. Cette cavité est généralement réalisée avec un matériau absorbant réalisé à partir, par exemple, d'une mousse que l'on vient charger en carbone ou en poudre de fer. Ce matériau absorbant a pour but de maximiser l'absorption du rayonnement arrière de l'antenne et donc de minimiser le rayonnement réfléchi sur le support afin d'éviter que l'onde réfléchie, en décalage de phase avec l'onde rayonnée vers l'avant ne perturbe le rayonnement de l'antenne.

Cependant, les matériaux absorbants utilisés pour supprimer le rayonnement arrière présentent certains inconvénients. Les propriétés absorbantes d'un matériau dépendant de la fréquence du rayonnement, le rayonnement arrière ne peut pas être absorbé sur de larges bandes de fréquence. Les caractéristiques électromagnétiques comme la permittivité et la perméabilité des absorbants varient d'une fabrication à l'autre entraînant une dispersion des performances rayonnées de l'antenne. Le poids et l'encombrement des matériaux absorbants augmentent rapidement quand la fréquence du rayonnement à absorber diminue, augmentant d'autant le poids et l'encombrement du support de l'antenne. Enfin, tout le rayonnement arrière étant inexploité, les pertes au niveau du gain, liées à l'absence de puissance réfléchie, sont importantes (au maximum 3dB).

Une autre solution vise à maximiser l'effet de la réflexion du rayonnement arrière, en assurant que l'onde électromagnétique réfléchie soit en phase avec l'onde incidente. Pour ce faire, un plan conducteur électrique ayant des propriétés de réflexion optimales est disposé à une distance de l'élément rayonnant égale au quart de la longueur d'onde du rayonnement que le dispositif antennaire émette ou reçoive. En effet, pour cette distance, le rayonnement arrière réfléchi se retrouve en phase avec le rayonnement avant. Ceci a pour effet de maximiser la puissance restituée par l'antenne.

Le principal inconvénient de cette solution est que la distance ne peut être ajustée de façon optimale que pour une seule longueur d'onde. Le rayonnement émis ou reçu à des longueurs d'onde éloignées de cette longueur d'onde centrale est perturbé, limitant, de fait, la largeur de bande de l'antenne. Un autre inconvénient de cette solution est que le quart de la longueur d'onde représente rapidement une distance importante pour les fréquences basses, ce qui engendre une épaisseur globale pour le dispositif antennaire relativement importante. En outre, le plan conducteur a des propriétés d'induction importantes et des phénomènes de réflexion et de diffraction se produisent au bord de l'antenne, générant ainsi des rayonnements parasites.

Il est également connu, notamment par les demandes de brevet WO 2004/093 244, US 2002/167 457 et FR 2 916 308 ainsi que par les publications de GAO Q ET AL: ^{«}Application of metamaterials to ultra-thin radar absorbing material design^{»} et de SCHREIDER L ET AL: ^{«}Broadband Archimedean spiral antenna above a loaded electromagnetic band gap substrate", d'utiliser un réflecteur d'antenne de type Bande Interdite Electromagnétique (BIE) ou EBG pour Eletromagnetic Band Gap selon la terminologie anglo-saxonne.

Une telle structure permet de maîtriser le rayonnement arrière pour s'affranchir des rayonnements parasites qu'il engendre. Elle peut présenter une des trois propriétés suivantes :
- Réfléchir le rayonnement arrière de l'élément rayonnant en phase avec le rayonnement avant.
- Absorber le rayonnement arrière.
- En fonction de la bande de fréquences de fonctionnement de l'antenne, absorber ou réfléchir le rayonnement arrière de l'élément rayonnant en phase avec le rayonnement avant.

Cette structure est placée entre l'élément rayonnant et son support. La face inférieure de la structure est composée d'un plan de masse sur lequel repose un matériau diélectrique qui supporte un réseau périodique d'éléments conducteurs métalliques ou patchs suivant le terme anglo-saxon. Actuellement dans la littérature scientifique l'élément rayonnant repose sur un réseau d'éléments conducteurs qui couvre une surface plus grande que l'élément rayonnant lui-même. Or, le substrat diélectrique doit présenter une surface au moins équivalente à celle du réseau de patchs de la structure à bande interdite électromagnétique pour pouvoir la supporter. Cette condition impose, pour des antennes travaillant à basse fréquence comme par exemple autour de la centaine de Mégahertz, de réaliser des structures à bande interdite électromagnétique qui présentent un encombrement et une masse élevés.

En fonction des applications, les patchs peuvent être reliés au plan de masse par l'intermédiaire de traversées conductrices ou vias. Dans ce cas, la bande de fréquence de fonctionnement de l'antenne est limitée.

Il est également connu, notamment par la demande de brevet FR 2 916 308, une structure dans laquelle les éléments conducteurs contigus du réseau sont reliés deux à deux par l'intermédiaire de résistances. On parle alors de LEBG pour Loaded Electromagnetic BandGap. Ce dernier type de structure large bande ne présente pas de résultats complètement satisfaisant en terme de performance électromagnétique. L'allure des diagrammes de rayonnement est dégradée en fin de bande de fonctionnement de l'antenne. En effet, ce type de structure génère, pour les fréquences hautes, l'apparition de lobes secondaires dont le niveau peut être supérieur au lobe principal. Ceci se traduit aussi par une diminution de l'ouverture à mi-puissance du lobe principal. De plus, pour une épaisseur de diélectrique donné, le gain dans l'axe radioélectrique de l'antenne n'est pas optimal par rapport au gain théorique attendu. En effet, le rayonnement arrière de l'antenne n'est pas réfléchi en phase avec le rayonnement avant or cette condition est requise pour un gain optimal.

Un but de l'invention est notamment de corriger les inconvénients précités. A cet effet, l'invention a pour objet un dispositif à bande interdite électromagnétique comprenant un support diélectrique dont une face est métallisée et dont la deuxième face comporte une pluralité d'éléments conducteurs non jointifs. Dans ce dispositif, plusieurs éléments conducteurs sont reliés entre eux deux à deux par un élément résistif, au moins deux éléments conducteurs sont électriquement isolés l'un de l'autre et au moins deux éléments résistifs présentent une valeur de résistance différente.

Selon une particularité, au moins deux éléments conducteurs contigus sont espacés d'une distance d₁ et au moins deux éléments conducteurs contigus sont espacés d'une distance d₂, les distances d₁ et d₂ étant différentes.

Selon une autre particularité au moins deux éléments conducteurs présentent des formes différentes.

Selon une autre particularité, au moins deux éléments conducteurs occupent une surface différente.

Selon une autre particularité, au moins un élément conducteur a une forme carré.

Selon une autre particularité, au moins un élément conducteur a une forme rectangulaire.

L'invention a également pour objet l'utilisation du dispositif précédemment cité dans un dispositif antennaire, ledit dispositif antennaire comprenant un ensemble comportant au moins un élément rayonnant disposé en vis-à-vis de la face du support du dispositif à bande interdite électromagnétique comportant les éléments conducteurs, cet ensemble comportant au moins un élément rayonnant étant isolée électriquement dudit dispositif à bande interdite électromagnétique.

Selon une particularité, l'ensemble comportant au moins un élément rayonnant comprend au moins une antenne filaire plane.

Selon une autre particularité, l'ensemble comportant au moins un élément rayonnant est séparé des éléments conducteurs par un substrat diélectrique.

Selon une autre particularité, au moins une des dimensions de la surface de cet ensemble comportant au moins un élément rayonnant est supérieure à au moins une des dimensions de la surface occupée par la totalité des éléments conducteurs du dispositif à bande interdite électromagnétique.

Un troisième objet de l'invention est de proposer un procédé de détermination des paramètres du dispositif antennaire. Ce procédé comprend :
- une étape de détermination des paramètres d'un motif élémentaire,
- Une étape de simulation d'un dispositif à bande interdite électromagnétique réalisé à partir du motif élémentaire,
- Une étape d'optimisation du dispositif à bande interdite électromagnétique,
- Une étape d'optimisation des motifs élémentaires,
- Une étape d'optimisation des éléments résistifs.

De façon avantageuse, la présente invention permet de réduire l'encombrement et la masse de la structure à bande interdite. L'invention a également pour avantage de permettre d'améliorer les performances électromagnétiques rayonnées des dispositifs antennaires sur une large bande de fréquences.

D'autres particularités et avantages de la présente invention apparaîtront plus clairement à la lecture de la description ci-après, donnée à titre illustratif et non limitatif, et faite en référence aux dessins annexés, dans lesquels :
- La figure 1 représente un exemple de réalisation d'un dispositif à bande interdite électromagnétique selon l'art antérieur,
- La figure 2 représente un exemple de réalisation d'un dispositif à bande interdite électromagnétique selon l'invention,
- La figure 3 représente un exemple de réalisation d'un dispositif antennaire selon l'invention.

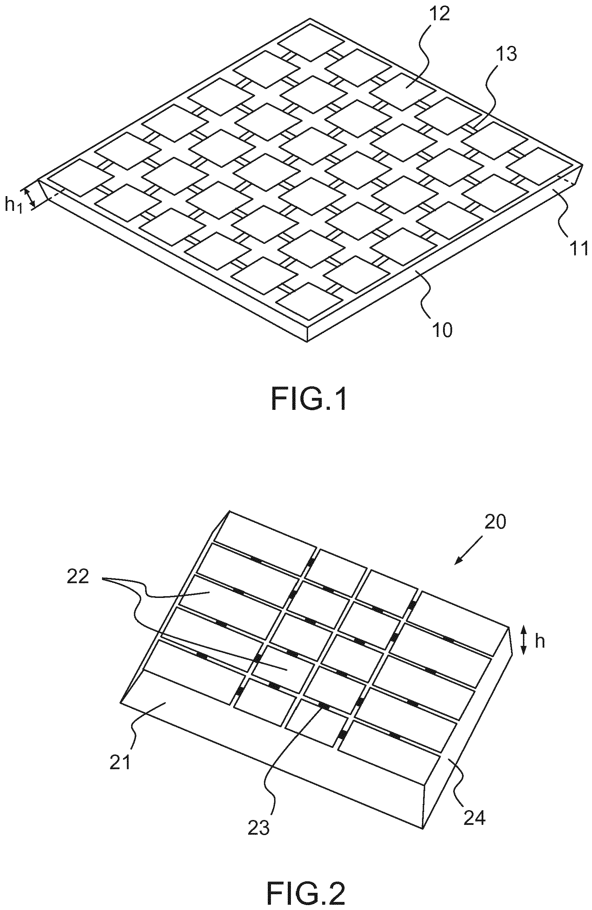

La figure 1 représente un exemple de réalisation d'un dispositif à Bande Interdite Electromagnétique (BIE) connue de l'art antérieur. Ce dispositif comporte un support plan 10 en matériau diélectrique de hauteur h₁. Une face 11 de ce support 10 est entièrement métallisée de façon à former un plan de masse. Sur la deuxième face est disposé un réseau d'éléments conducteurs 12 identiques non jointifs disposés de façon régulière en rangée et colonne. Chaque élément conducteur est de forme carré et chaque espace séparant deux éléments conducteurs contigus à la même longueur. Chacun des éléments conducteurs contigus sont reliés deux à deux par une résistance 13. Chaque résistance du dispositif a la même valeur.

Ce dispositif peut être utilisé comme support pour une antenne filaire afin de former un dispositif antennaire. Dans cette utilisation, le dispositif BIE a également une fonction de réflecteur pour les ondes rayonnées en direction dudit dispositif BIE. Un inconvénient de ce dispositif antennaire est que la surface couverte par le réseau d'éléments conducteurs 12 est supérieure à celle occupée par l'élément rayonnant rendant le dispositif antennaire encombrant et plus lourd, pénalisant l'intégration dans un porteur.

La figure 2 représente un exemple de réalisation d'un dispositif à bande interdite électromagnétique 20 suivant l'invention. Dans cet exemple de réalisation, le dispositif comprend un support diélectrique 24 de hauteur h dont une face 21 est métallisée pour former un plan conducteur faisant office de plan de masse. La deuxième face comporte une pluralité d'éléments conducteurs 22 non jointifs. Certains éléments conducteurs contigus sont reliés deux par deux par un élément résistif 23 et d'autres ne sont pas reliés entre eux par un élément résistif 23 et sont donc isolés électriquement. Par rapport à la structure présentée en figure 1, la structure de la présente invention forme un dispositif à bande interdite électromagnétique partiellement chargé. Dans certains modes de réalisation, toutes les résistances 23 n'ont pas la même valeur ainsi au moins deux éléments résistifs 23 ont des valeurs de résistance différentes. Suivant une variante de réalisation, tous les éléments résistifs ont la même valeur.

Contrairement à certains dispositifs à bande interdite électromagnétique de l'art antérieur, les différents éléments conducteurs ne sont pas reliés au plan de masse 21 par un via mais sont disposés flottant par rapport audit plan conducteur 21.

L'invention emploie des techniques de fabrication maîtrisées et met en oeuvre la technologie de type circuit imprimé qui permet une bonne reproductibilité des performances du dispositif à bande interdite électromagnétique. Ainsi, le substrat du support du dispositif 20 peut être une carte de circuit imprimé et le diélectrique utilisé de l'époxy. Les éléments conducteurs 22 et le plan de masse 21 peuvent être directement gravés sur la carte de circuit imprimé.

Suivant un mode de réalisation particulier, chacun des éléments conducteurs 22 contigus sont reliés deux par deux par un élément résistif 23.

Suivant une particularité de l'invention, tous les éléments conducteurs 22 peuvent ne pas avoir la même forme géométrique. Certains éléments conducteurs peuvent avoir une forme carrée, d'autre une forme rectangulaire ou tout autre forme géométrique possible. Bien entendu, l'invention englobe également le cas où tous les éléments conducteurs ont la même forme.

Suivant un mode de réalisation, au moins deux éléments conducteurs 22 ont au moins une dimension différente (indifféremment largeurs, longueurs ou les deux).

Comme vu précédemment, les éléments conducteurs 22 du dispositif à bande interdite électromagnétique ne sont pas jointifs. Suivant un mode de réalisation, tous les espaces entre les éléments conducteurs 22 sont identiques. Suivant une variante de réalisation, tous les éléments conducteurs contigus ne sont pas espacés de la même distance. Ainsi certains éléments conducteurs contigus sont espacés d'une distance d₁ et d'autres d'une distance d₂ avec d₁ et d₂ différentes.

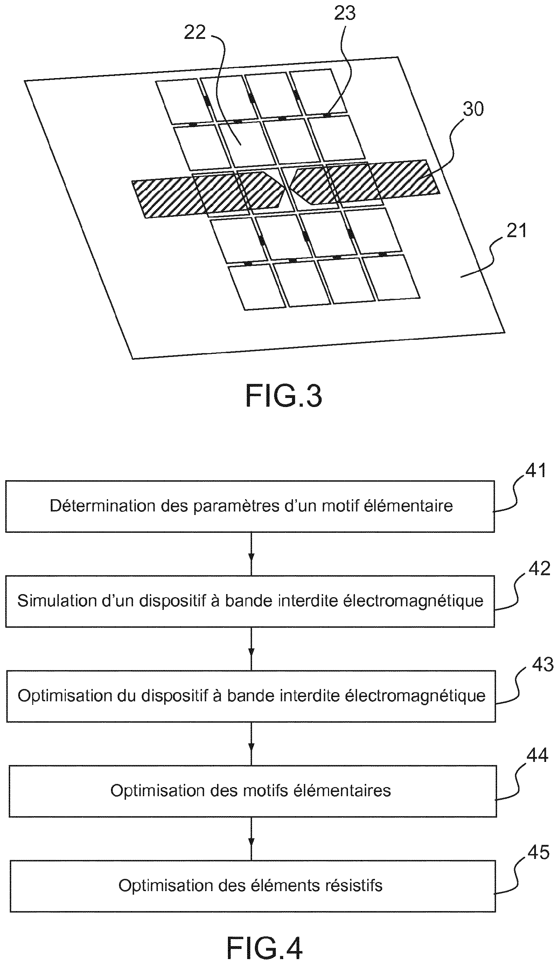

La figure 3 illustre un exemple d'utilisation du dispositif 20 à bande interdite électromagnétique selon l'invention. Dans cet exemple, le dispositif 20 est utilisé dans un dispositif antennaire en association avec un élément rayonnant 30.

D'une façon générale, le dispositif à bande interdite électromagnétique peut être utilisé dans un dispositif antennaire comprenant un ensemble comportant un ou plusieurs éléments rayonnants 30. Le ou les éléments rayonnants 30 sont disposés en vis-à-vis de la face du support du dispositif 20 à bande interdite électromagnétique comportant les éléments conducteurs 22. L'ensemble comportant le ou les éléments rayonnants 30 sont isolés électriquement du dispositif à bande interdite électromagnétique. Suivant un exemple de réalisation, les éléments conducteurs 22 sont séparés du ou des éléments rayonnants 30 par un substrat diélectrique. Ce substrat peut, par exemple, être une plaque de circuit imprimé et l'élément rayonnant être directement gravée sur une face de cette plaque.

De façon à alimenter le ou les éléments rayonnants 30, au moins un trou dans le substrat diélectrique 24 et le plan de masse 21 du dispositif à bande interdite électromagnétique est pratiqué afin de faire passer le ou les fils d'alimentation de l'élément rayonnant ou des éléments rayonnants 30. De façon similaire, au moins un trou est réalisé dans le substrat séparant l'antenne 30 des éléments conducteurs 22 pour faire passer le ou les fils d'alimentation.

L'ensemble comprenant le ou les éléments rayonnants 30 peut comporter au moins une antenne filaire plane. Tous les types d'antennes filaires planes peuvent être mises en oeuvre dans l'invention et ce quelle que soit leur polarisation. Le ou les éléments rayonnants peuvent par exemple être des antennes plaquées ou antenne patch selon la terminologie anglo-saxonne.

Suivant un mode de réalisation particulier, au moins une des dimensions de la surface de l'ensemble comportant au moins un élément rayonnant 30 est supérieure à au moins une des dimensions de la surface occupée par la pluralité d'éléments conducteurs 22 du dispositif à bande interdite électromagnétique 20. Dans l'exemple illustré figure 3, la pluralité d'éléments conducteurs 22 ne couvre pas toute la surface occupée par l'antenne 30 dans le sens de sa longueur. Bien entendu, l'invention couvre également le cas où la surface occupée par la pluralité d'éléments conducteurs 22 est supérieure à celle de l'ensemble comportant au moins un élément rayonnant 30.

De façon avantageuse, la diminution de la surface occupée par les éléments conducteurs 22 permet de diminuer, l'encombrement et la masse du matériau diélectrique supportant les éléments conducteurs 22. Cette diminution permet aussi d'améliorer les performances électromagnétiques rayonnées de l'antenne sur une large bande de fréquences par rapport à une structure à bande interdite électromagnétique classique chargée par des résistances. Ces performances peuvent être obtenues sur une bande de fréquences supérieure à l'octave et pouvant atteindre la décade en fonction de la bande de fréquences considérées.

En référence à la figure 4 un procédé de détermination des différents paramètres d'un dispositif antennaire suivant l'invention est présenté.

Il est connu que la différence de phase entre l'onde électromagnétique incidente et celle réfléchie au niveau de la surface d'un dispositif à bande interdite électromagnétique, en fonction de la fréquence, détermine la plage de fonctionnement de ce dispositif. C'est-à-dire la bande de fréquences sur laquelle le rayonnement arrière, réfléchi sur le dispositif à bande interdite électromagnétique, est en phase avec le rayonnement avant. Par convention la plage de fréquence considérée ou bande interdite est définie lorsque la phase du coefficient de réflexion varie entre +90° et -90°.

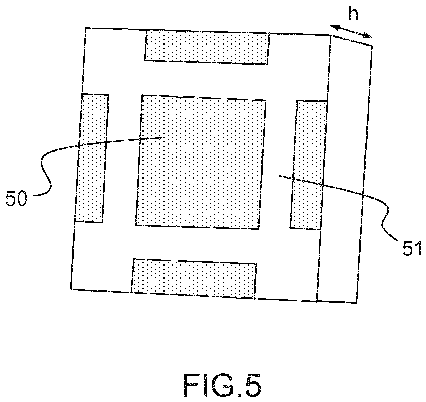

Les différents paramètres du dispositif à bande interdite électromagnétique sont déterminés par modélisation numérique. La forme d'un motif élémentaire 50 destiné à former les éléments conducteurs du dispositif à bande interdite électromagnétique est choisie. A titre d'exemple, la figure 5 illustre un cas dans lequel un motif élémentaire 50 de forme carré placé sur un substrat 51 de hauteur h à été choisi. La méthode de l'onde réfléchie, mise en oeuvre par un logiciel de simulation électromagnétique permet ensuite d'affiner les dimensions du motif élémentaire 50 et la distance séparant chaque motif élémentaire 50. Cette méthode, mise en oeuvre au cours d'une étape 41 de détermination des paramètres du motif élémentaire, permet aussi de choisir le substrat diélectrique et de fixer son épaisseur h. Le principe consiste à illuminer un motif élémentaire 50, périodisé par des conditions aux limites, par une onde plane avec une incidence normale. Les dimensions du motif élémentaire 50 sont, si besoin, optimisées jusqu'à obtenir une bande interdite centrée sur la plage de fréquences de fonctionnement du dispositif antennaire désiré.

Une fois les dimensions du motif élémentaire 50 déterminées, ce motif est utilisé pour former un dispositif à bande interdite électromagnétique comme présenté figure 1. On considère donc un dispositif à bande interdite électromagnétique formé par un réseau d'éléments conducteurs identiques non jointifs ayant les mêmes caractéristiques que le motif élémentaire déterminé. Ce réseau est placé sur une des faces d'un substrat diélectrique dont la nature et la hauteur ont été déterminées par la méthode précédente. La deuxième face du substrat diélectrique est entièrement métallisée de façon à former un plan de masse. Chacun des éléments conducteurs contigus sont espacés d'une distance identique déterminée au cours de l'étape précédente.

Une telle structure, associée à l'élément rayonnant considéré est ensuite simulée au cours d'une étape de simulation 42. Pour cette simulation, la valeur de l'élément résistif est choisie, par exemple, égale à l'impédance du vide à savoir 377 Ohms.

Une optimisation de l'encombrement et de la masse du dispositif à bande interdite électromagnétique ainsi que des performances rayonnées de l'antenne associée est réalisé au cours d'une étape 43 d'optimisation du dispositif à bande interdite électromagnétique. Ce travail d'optimisation porte sur le réseau de motifs élémentaires 50 placé sous l'élément rayonnant. L'objectif est de diminuer la surface occupée par le réseau tout en optimisant les performances rayonnées du dispositif antennaire réalisé. Par exemple, les motifs élémentaires 50 placés sur la couronne extérieure du dispositif à bande interdite électromagnétique, peuvent être supprimés.

Lorsque le réseau comporte moins de motifs élémentaires 50, une nouvelle étape 44 d'optimisation des motifs élémentaires conducteurs est réalisée. Lors de cette étape, les dimensions des motifs élémentaires 50 sont modifiées de façon à optimiser les performances rayonnées du dispositif antennaire réalisé. Suivant un exemple nullement limitatif, l'augmentation de l'un des côtés des motifs élémentaires 50 carrés situés aux deux extrémités du dispositif à bande interdite électromagnétique peut améliorer le gain dans l'axe de l'antenne. A la fin de cette étape chaque motif élémentaire 50 a été optimisé pour former les éléments conducteurs 22 du dispositif à bande interdite électromagnétique 20 final.

Pour terminer la réalisation, une étude de l'influence de la valeur des éléments résistifs 23 ainsi que leur position est réalisée au cours d'une étape d'optimisation des éléments résistifs 45. Par exemple, dans le cas d'une antenne 30 formée par un élément rayonnant de type dipôle, l'absence d'éléments résistifs 23 dans les plans principaux de l'antenne 30 permet d'améliorer considérablement l'ouverture à mi-puissance et permet de diminuer le niveau des lobes secondaires du dispositif antennaire.

## Revendications

1. Dispositif (20) à bande interdite électromagnétique comprenant un support diélectrique dont une face (21) est métallisée et dont la deuxième face comporte une pluralité d'éléments conducteurs (22) non jointifs, plusieurs éléments conducteurs étant reliés entre eux deux à deux par un élément résistif (23) à l'exception d'au moins deux éléments conducteurs (22) contigus, au moins deux éléments conducteurs (22) contigus étant espacés d'une distance d₁ et au moins deux éléments conducteurs (22) contigus étant espacés d'une distance d₂, les distances d₁ et d₂ étant différentes, ledit dispositif (20) étant **caractérisé en ce qu'**au moins deux éléments résistifs (23) présentent une valeur de résistance différente.

2. Dispositif selon une des revendications précédentes **caractérisé en ce qu'**au moins deux éléments conducteurs (22) présentent des formes différentes.

3. Dispositif selon une des revendications précédentes **caractérisé en ce qu'**au moins deux éléments conducteurs (22) occupent une surface différente.

4. Dispositif selon une des revendications précédentes **caractérisé en ce qu'**au moins un élément conducteur (22) a une forme carré.

5. Dispositif selon une des revendications précédentes **caractérisé en ce qu'**au moins un élément conducteur (22) a une forme rectangulaire.

6. Utilisation du dispositif (20) à bande interdite électromagnétique selon une des revendications précédentes dans un dispositif antennaire **caractérisée en ce que** ledit dispositif antennaire comporte un ensemble comportant au moins un élément rayonnant (30) disposé en vis-à-vis de la face du support du dispositif (20) à bande interdite électromagnétique comportant les éléments conducteurs (22), cet ensemble comportant au moins un élément rayonnant (30) étant isolé électriquement dudit dispositif à bande interdite électromagnétique.

7. Utilisation du dispositif (20) à bande interdite électromagnétique selon la revendication précédente **caractérisée en ce que** l'ensemble comportant au moins un élément rayonnant (30) comprend au moins une antenne filaire plane.

8. Utilisation du dispositif (20) à bande interdite électromagnétique selon une des revendications 6 à 7 **caractérisée en ce que** l'ensemble comportant au moins un élément rayonnant (30) est séparé des éléments conducteurs (22) par un substrat diélectrique.

9. Utilisation du dispositif (20) à bande interdite électromagnétique selon une des revendications 6 à 8 **caractérisée en ce que** la projection dans le plan contenant la pluralité d'éléments conducteurs (22) d'au moins un élément rayonnant (30) dépasse de la surface occupée par la totalité des éléments conducteurs (22) du dispositif (20) à bande interdite électromagnétique.

10. Procédé de détermination des paramètres du dispositif (20) à bande interdite électromagnétique selon une des revendications 1 à 5 **caractérisé en ce qu'**il comprend :
- une étape (41) de détermination des paramètres d'un motif élémentaire (50),
- Une étape (42) de simulation d'un dispositif à bande interdite électromagnétique réalisé à partir du motif élémentaire,
- Une étape (43) d'optimisation du dispositif à bande interdite électromagnétique,
- Une étape (44) d'optimisation des motifs élémentaires,
- Une étape (45) d'optimisation des éléments résistifs.

## Patentansprüche

1. Vorrichtung (20) mit elektromagnetischer Bandlücke, die eine dielektrische Auflage umfasst, deren eine Fläche (21) metallisiert ist und deren zweite Fläche mehrere nicht zusammengefügte Leiterelemente (22) umfasst, wobei mehrere Leiterelemente paarweise miteinander durch ein Widerstandselement (23) verbunden sind, mit Ausnahme von wenigstens zwei zusammenhängenden Leiterelementen (22), wobei wenigstens zwei zusammenhängende Leiterelemente (22) um eine Distanz d₁ beabstandet sind und wenigstens zwei zusammenhängende Leiterelemente (22) um eine Distanz d₂ beanstandet sind, wobei die Distanzen d₁ und d₂ unterschiedlich sind, wobei die Vorrichtung (20) **dadurch gekennzeichnet ist, dass** wenigstens zwei Widerstandselemente (23) einen anderen Widerstandswert haben.

2. Vorrichtung nach dem vorherigen Anspruch, **dadurch gekennzeichnet, dass** wenigstens zwei Leiterelemente (22) unterschiedliche Formen haben.

3. Vorrichtung nach einem der vorherigen Ansprüche, **dadurch gekennzeichnet, dass** wenigstens zwei Leiterelemente (22) eine andere Fläche belegen.

4. Vorrichtung nach einem der vorherigen Ansprüche, **dadurch gekennzeichnet, dass** wenigstens ein Leiterelement (22) eine quadratische Form hat.

5. Vorrichtung nach einem der vorherigen Ansprüche, **dadurch gekennzeichnet, dass** wenigstens ein Leiterelement (22) eine rechteckige Form hat.

6. Verwendung der Vorrichtung (20) mit elektromagnetischer Bandlücke nach einem der vorherigen Ansprüche in einer Antennenvorrichtung, **dadurch gekennzeichnet, dass** die Antennenvorrichtung ein Set umfasst, das wenigstens ein Strahlungselement (30) umfasst, das gegenüber der Fläche der Auflage der die Leiterelemente (22) umfassenden Vorrichtung (20) mit elektromagnetischer Bandlücke angeordnet ist, wobei dieses wenigstens ein Strahlungselement (30) umfassende Set elektrisch von der Vorrichtung mit elektromagnetischer Bandlücke isoliert ist.

7. Verwendung der Vorrichtung (20) mit elektromagnetischer Bandlücke nach dem vorherigen Anspruch, dass gekennzeichnet, dass das wenigstens ein Strahlungselement (30) umfassende Set wenigstens eine ebene Drahtantenne umfasst.

8. Verwendung der Vorrichtung (20) mit elektromagnetischer Bandlücke nach den Ansprüchen 6 bis 7, **dadurch gekennzeichnet, dass** das wenigstens ein Strahlungselement (30) umfassende Set durch ein dielektrisches Substrat von den Leiterelementen (22) getrennt ist.

9. Verwendung der Vorrichtung (20) mit elektromagnetischer Bandlücke nach einem der Ansprüche 6 bis 8, **dadurch gekennzeichnet, dass** die Projektion in der Ebene, die die mehreren Leiterelemente (22) von wenigstens einem Strahlungselement (30) enthält, über die Oberfläche hinausgeht, die von der Gesamtheit der Leiterelemente (22) der Vorrichtung (20) mit elektromagnetischer Bandlücke belegt ist.

10. Verfahren zum Bestimmen von Parametern der Vorrichtung (20) mit elektromagnetischer Bandlücke nach einem der Ansprüche 1 bis 5, **dadurch gekennzeichnet, dass** es Folgendes beinhaltet:
- einen Schritt (41) des Feststellens der Parameter eines elementaren Motivs (50),
- einen Schritt (42) des Simulierens einer Vorrichtung mit elektromagnetischer Bandlücke, die auf der Basis des elementaren Motivs realisiert wurde,
- einen Schritt (43) des Optimierens der Vorrichtung mit elektromagnetischer Bandlücke,
- einen Schritt (44) des Optimierens der elementaren Motive,
- ein Schritt (45) des Optimierens der Widerstandselemente.

## Claims

1. An electromagnetic band gap device (20) comprising a dielectric support of which one face (21) is metallised and the second face of which comprises a plurality of non-adjoining conductive elements (22), several conductive elements being linked together in pairs by a resistive element (23) with the exception of at least two contiguous conductive elements (22), at least two contiguous conductive elements (22) being spaced apart by a distance d₁, and at least two contiguous conductive elements (22) being spaced apart by a distance d₂, distances d₁ and d₂ being different, said device (20) being **characterised in that** at least two resistive elements (23) exhibit a different resistance value.

2. The device according to the preceding claim, **characterised in that** at least two conductive elements (22) exhibit different shapes.

3. The device according to any of the preceding claims, **characterised in that** at least two conductive elements (22) occupy a different surface area.

4. The device according to any of the preceding claims, **characterised in that** at least one conductive element (22) has a square shape.

5. The device according to any of the preceding claims, **characterised in that** at least one conductive element (22) has a rectangular shape.

6. The use of the electromagnetic band gap device (20) according to any of the preceding claims in an antenna device, **characterised in that** said antenna device comprises an assembly that includes at least one radiating element (30) disposed opposite the face of the support of the electromagnetic band gap device (20) comprising the conductive elements (22), this assembly comprising at least one radiating element (30) that is electrically isolated from said electromagnetic band gap device.

7. The use of the electromagnetic band gap device (20) according to the preceding claim, **characterised in that** the assembly comprising at least one radiating element (30) comprises at least one planar wire antenna.

8. The use of the electromagnetic band gap device (20) according to any of claims 6 to 7, **characterised in that** the assembly comprising at least one radiating element (30) is separated from the conductive elements (22) by a dielectric substrate.

9. The use of the electromagnetic band gap device (20) according to any of claims 6 to 8, **characterised in that** the projection into the plane containing the plurality of conductive elements (22) of at least one radiating element (30) goes beyond the surface area occupied by all of the conductive elements (22) of the electromagnetic band gap device (20).

10. A method for determining the parameters of the electromagnetic band gap device (20) according to any of claims 1 to 5, **characterised in that** it comprises:
- a step (41) of determining the parameters of an elementary pattern (50),
- a step (42) of simulating an electromagnetic band gap device produced on the basis of the elementary pattern,
- a step (43) of optimising the electromagnetic band gap device,
- a step (44) of optimising the elementary patterns,
- a step (45) of optimising the resistive elements.
